# EUROPEAN PATENT APPLICATION

(11) **EP 3 723 287 A1**
(43) Date of publication of application: **14.10.2020**
(21) Application number: 19168650.0
(22) Date of filing: 11.04.2019
(51) Int. Cl.: H03K 17/0412, B06B 1/02

(54) **ULTRASOUND TRANSDUCER DRIVER CIRCUIT**

(71) Applicant: Koninklijke Philips N.V., 5656 AG Eindhoven (NL)
(72) Inventor: BLANKEN, Pieter Gerrit, 5656 AE Eindhoven (NL); OP HET VELD, Johannes Hubertus Gerardus, 5656 AE Eindhoven (NL)
(74) Representative: de Haan, Poul Erik

(57) **Abstract**

An ultrasound transducer driver circuit (UTDC) includes a half-bridge output stage for driving an ultrasound transducer (UST). The half-bridge output stage includes a high-side transistor (MPO) and a low-side transistor (MNO), a level-shifter (LSH, MN1, Rl), and a discharge switch (DSW, MP2). The discharge switch (DSW, MP2) controls a switching rate of the high-side transistor (MPO) by discharging an input capacitance of the high-side transistor (MPO) when the high-side transistor (MPO) is switched into the non-conducting state by, in a first implementation i) discharging a gate-source capacitance of the output p-channel FET (MPO), or in a second implementation ii) discharging a base-emitter capacitance of the output pnp bipolar transistor.

## Description

### FIELD OF THE INVENTION

The invention relates to an ultrasound transducer driver circuit. The circuit may be used in a variety of ultrasound imaging, sensing and measurement systems including medical ultrasound imaging systems. Its use in both 2D and 3D ultrasound imaging systems is contemplated. The circuit may for example be used in intravascular "IVUS" ultrasound imaging systems, as well as in transesophageal "TEE", transthoracic "TTE", transnasal "TNE", intracardiac "ICE", and transrectal "TRUS", ultrasound imaging systems. The ultrasound transducer driver circuit is contemplated for use in driving ultrasound transducers in general, and may exemplarily be used to drive a capacitive micromachined ultrasound transducer "CMUT", or a piezoelectric ultrasound transducer.

### BACKGROUND OF THE INVENTION

Various ultrasound transducer driver circuits have been developed in order to address the combined demands of low power consumption and fast switching at the high switching voltages encountered in ultrasound imaging, sensing and measurement applications. These challenging demands are further compounded by the tight space constraints and long cable lengths encountered in the exemplary application area of IVUS imaging. The ultrasound transducers used in these applications typically require voltages that are in the order of a few tens of volts to be switched within a period of from a few nanoseconds to a few microseconds. Often a combination of so-called high-voltage FETs, defined herein as having a drain-source breakdown voltage exceeding its gate-source breakdown voltage, and so-called low-voltage FETs, defined herein as having a drain-source breakdown voltage that is less than or equal to its gate-source breakdown voltage; or a combination of so-called high-voltage bipolar transistors, defined herein as having a collector-emitter breakdown voltage exceeding its base-emitter breakdown voltage, and so-called low-voltage bipolar transistors, defined herein as having a collector-emitter breakdown voltage that is less than or equal to its base-emitter breakdown voltage; integrated circuit, IC, technologies are used to fabricate the transistors used in the respective driving and control portions of these circuits. By today's integrated-circuit standards a high-voltage FET or bipolar transistor typically has an operational voltage that exceeds 3.3 Volts, and a low-voltage FET or bipolar transistor typically has an operational voltage that is less than or equal to 3.3 Volts.

One type of driver circuit used in switching voltages of a few tens of volts includes a so-called half-bridge output stage. A half-bridge output stage includes a high-side transistor and a low-side transistor coupled between two power rails. The high-side transistor is coupled to a first power rail that supplies a first voltage, and the low-side transistor is coupled to a second power rail that supplies a second voltage, the second voltage being relatively lower than the first voltage. A common connection between the two transistors serves as an output terminal and is connected to a first electrode of a load. A second electrode of the load is connected to a bias voltage or zero volts. By alternately switching each of the high-side and low-side transistors between the conducting and non-conducting states such that they are in opposite states, a voltage on the first electrode is modulated between the first voltage and the second voltage.

In this respect, a document by Eric J. Wildi, John P. Walden, Michael S. Adler entitled "A 500V/25A half-bridge IC with on-chip control logic", Digest of Technical Papers of the 28th IEEE International Solid-State Circuits Conference ISSCC1985, New York, USA, Feb. 1985, pp. 266 - 267 discloses a driver circuit that includes a half-bridge output stage.

A half-bridge output stage is also known from US patent US 4,994,955.

In spite of these developments there remains room to provide an improved circuit for driving an ultrasound transducer.

### SUMMARY OF THE INVENTION

The invention seeks to provide an improved circuit for driving an ultrasound transducer. Thereto, an ultrasound transducer driver circuit is provided as defined in claim 1. An application specific integrated circuit and an ultrasound imaging system that incorporate the ultrasound transducer driver circuit are also provided.

The ultrasound transducer driver circuit includes a half-bridge output stage for driving an ultrasound transducer. The half-bridge output stage includes a high-side transistor and a low-side transistor. The ultrasound transducer driver circuit also includes a level-shifter and a discharge switch. In a first implementation i) the high-side transistor includes an output p-channel FET and the low-side transistor includes an output n-channel FET. In a second implementation ii) the high-side transistor includes an output pnp bipolar transistor and the low-side transistor includes an output npn bipolar transistor. The level-shifter switches the high-side transistor between a conducting state and a non-conducting state by respectively controlling in the first implementation i) a gate-source voltage of the output p-channel FET, or in the second implementation ii) a base-emitter voltage of the output pnp bipolar transistor. According to the present disclosure, the discharge switch controls a switching rate of the high-side transistor by discharging an input capacitance of the high-side transistor when the high-side transistor is switched into the non-conducting state by, in the first implementation i) discharging a gate-source capacitance of the output p-channel FET, or in the second implementation ii) discharging a base-emitter capacitance of the output pnp bipolar transistor.

A shortcoming of known ultrasound transducer driver circuits that is addressed in the present disclosure is the limited switching rate of the high-side transistor, and consequently the switching rate of power to the ultrasound transducer. This issue can be particularly acute when high-voltage transistors are employed in the half-bridge output stage and/ or in the level-shifter in order to facilitate the switching of voltages in some ultrasound transducers. Thus, according to the present disclosure, the discharge switch accelerates switching-off the power to the high-side transistor by, in the first implementation, i) discharging a gate-source capacitance of the output p-channel FET, or in the second implementation ii) discharging a base-emitter capacitance of the output pnp bipolar transistor. This provides fast switching of the high-side transistor.

In accordance with one aspect the ultrasound transducer driver is further provided with a control circuit. The control circuit controls the level-shifter and also a control input of the low-side transistor such that the low-side transistor and the high-side transistor are alternately switched into each of the conducting state and the non-conducting state. The control circuit also causes the discharge switch to discharge the input capacitance of the high-side transistor when the high-side transistor is switched into the non-conducting state. The control circuit may employ a low-voltage IC technology, advantageously allowing for the use of low-power and more area-efficient integrated circuits.

In accordance with another aspect the control circuit includes a break-before-make switching operation wherein the high-side transistor is switched into the non-conducting state before the low-side transistor is switched into the conducting state, and wherein the low-side transistor is switched into the non-conducting state before the high-side transistor is switched into the conducting state. The break-before-make switching operation may reduce power consumption during switching the high-side and low-side transistor.

In accordance with another aspect the level-shifter includes a first current source and a first pullup component that together modulate a voltage applied to a control input of the high-side transistor by alternately switching a current generated by the first current source between a first magnitude and a second magnitude such that the high-side transistor is respectively switched between the conducting state and the non-conducting state. The second magnitude may be smaller than the first magnitude.

In accordance with another aspect the ultrasound transducer driver circuit includes a control circuit. The control circuit is configured to control the level-shifter and a control input of the low-side transistor such that the low-side transistor and the high-side transistor are alternately switched into each of the conducting state and the non-conducting state. The control circuit is further configured to cause the discharge switch to discharge the input capacitance of the high-side transistor when the high-side transistor is switched into the non-conducting state. The ultrasound transducer driver circuit also includes a second half-bridge output stage for driving a second ultrasound transducer, the second half-bridge output stage comprising a second high-side transistor and a second low-side transistor; a third level-shifter; and a second discharge switch. In a first implementation i) the second high-side transistor includes a second output p-channel FET and the second low-side transistor includes a second output n-channel FET. In a second implementation ii) the second high-side transistor includes a second output pnp bipolar transistor and the second low-side transistor includes a second output npn bipolar transistor. The third level-shifter is configured to switch the second high-side transistor between a conducting state and a non-conducting state by respectively controlling, in the first implantation i) a gate-source voltage of the second output p-channel FET, or in the second implantation ii) a base-emitter voltage of the second output pnp bipolar transistor. The second discharge switch is configured to control a switching rate of the second high-side transistor by discharging an input capacitance of the second high-side transistor when the second high-side transistor is switched into the non-conducting state by respectively, in the first implantation i) discharging a gate-source capacitance of the second output p-channel FET, or in the second implantation ii) discharging a base-emitter capacitance of the second output pnp bipolar transistor. The control circuit is further configured to control the third level-shifter and a control input of the second low-side transistor such that the second low-side transistor and the second high-side transistor are alternately switched into each of the conducting state and the non-conducting state. The control circuit is further configured to cause the second discharge switch to discharge the input capacitance of the second high-side transistor simultaneously with the discharging of the input capacitance of the first high-side transistor by the discharge switch.

Thus, the control circuit may be used to simultaneously control both the first and the second ultrasound transducers, advantageously ensuring that ultrasound emissions are terminated simultaneously and also limiting the amount of control circuitry and thus integrated circuit area that is needed to achieve this.

Additional half-bridge output stages for driving an ultrasound transducer, each with their corresponding level-shifter and discharge switch, and controlled in a corresponding manner by the control circuit, may also be provided in a similar manner in order to drive more than two ultrasound transducers and take advantage of the same benefits.

Further aspects and their advantages are described with reference to the appended claims.

### BRIEF DESCRIPTION OF THE FIGURES

Fig. 1 illustrates an ultrasound transducer driver circuit UTDC that includes a half-bridge output stage MP0, MN0, a discharge switch DSW and a level-shifter LSH.
Fig. 2 illustrates an ultrasound transducer driver circuit UTDC that includes a control circuit CTRL.
Fig. 3 illustrates an ultrasound transducer driver circuit UTDC that includes an exemplary level-shifter provided by first current source MN1 and first pullup component R1.
Fig. 4 illustrates another ultrasound transducer driver circuit UTDC that includes an exemplary level-shifter provided by first current source MN1 and first pullup component R1.
Fig. 5 illustrates an ultrasound transducer driver circuit UTDC that includes a second level-shifter exemplarily provided by second current source MN2 and second pullup component R2.
Fig. 6 illustrates an ultrasound transducer driver circuit UTDC that includes a second half-bridge output stage MP0', MN0' for driving a second ultrasound transducer UST'.
Fig. 7 illustrates an ultrasound transducer driver circuit UTDC that includes a second half-bridge output stage MP0', MN0' for driving a second ultrasound transducer UST' and a second level-shifter provided by second current source MN2 and second pullup component R2.

### DETAILED DESCRIPTION OF THE INVENTION

In order to illustrate the principles of the present invention an ultrasound transducer driver circuit is described with reference to the exemplary application of driving a CMUT transducer in an IVUS imaging system. It is however to be understood that the ultrasound transducer driver circuit finds application in the ultrasound imaging field in general and is not limited to this exemplary use. Use of the ultrasound transducer driver circuit is contemplated in a variety of ultrasound imaging, sensing and measurement systems including medical ultrasound imaging systems. Its use in both 2D and 3D ultrasound imaging systems is contemplated. The circuit may for example be used in intravascular "IVUS" ultrasound imaging systems, as well as in transesophageal "TEE", transthoracic "TTE", transnasal "TNE", intracardiac "ICE", and transrectal "TRUS", ultrasound imaging systems. The ultrasound transducer driver circuit is contemplated for use in driving ultrasound transducers in general, and may exemplarily be used to drive a capacitive micromachined ultrasound transducer "CMUT", or a piezoelectric ultrasound transducer, or indeed ultrasound transducers formed from other materials.

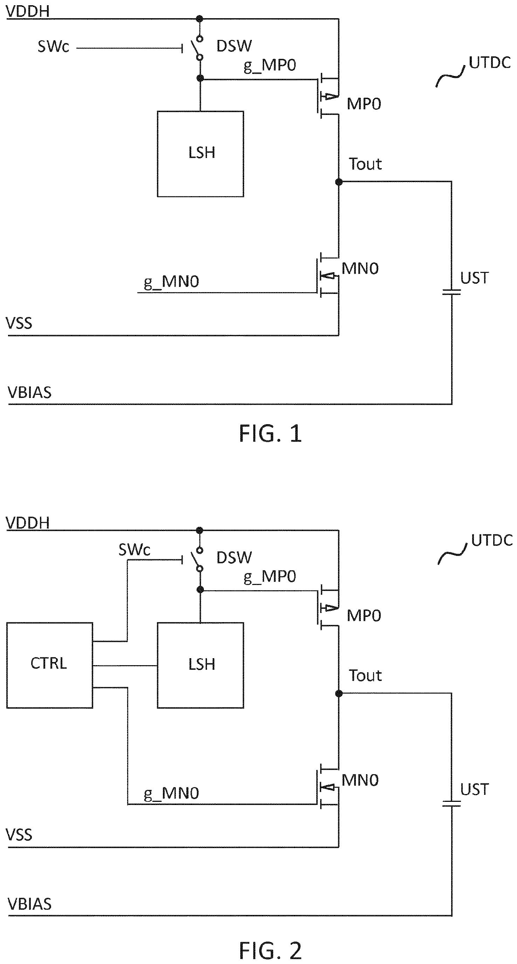

Fig. 1 illustrates an ultrasound transducer driver circuit UTDC that includes a half-bridge output stage MP0, MN0, a discharge switch DSW and a level-shifter LSH. Ultrasound transducer driver circuit UTDC may be used, as illustrated, to drive optional ultrasound transducer UST, which may for example be a CMUT transducer forming part of an array of such transducers within an IVUS imaging system. Half-bridge output stage MP0, MN0 includes high-side output transistor MP0 and low-side output transistor MN0 that are coupled in series between first power rail VDDH and second power rail VSS. More specifically, in a first implementation wherein a p-channel FET serves as high-side transistor MP0 and an n-channel FET serves as low-side transistor MN0, a source of high-side transistor MP0 may be coupled to first power rail VDDH and a source of low-side transistor MN0 may be coupled to second power rail VSS. First power rail VDDH may be arranged to supply a first voltage, and second power rail VSS may be arranged to supply a second voltage, the first voltage being relatively higher than the second voltage. The first voltage may be approximately 30 - 40 Volts and the second voltage may be approximately 0 Volts. These values are however purely exemplary. A common connection between high-side transistor MP0 and low-side transistor MN0, more specifically a drain of each FET, serves as output terminal Tout, which may be used to drive optional ultrasound transducer UST.

Where (MOS)FETs are referred-to in this disclosure, it is preferred that so-called enhancement devices are used. Moreover, it is to be understood that in any of the Figures illustrated herein, or in the description, a pnp bipolar transistor may be used in place of any p-channel FET, and an npn bipolar transistor may be used in place of any n-channel FET. Thus, in a second implementation, bipolar transistors are used in the half-bridge output stage of Fig. 1. In this second implementation a pnp bipolar transistor serves as high-side transistor MP0 and an npn bipolar transistor serves as low-side transistor MN0. The pnp bipolar transistor and the npn bipolar transistor are coupled in series between first power rail VDDH and second power rail VSS such that an emitter of the output pnp bipolar transistor is coupled to the first power rail VDDH and an emitter of the output npn bipolar transistor is coupled to the second power rail VSS. In this second implementation a collector of the output pnp bipolar transistor is coupled to a collector of the output npn bipolar transistor and this common connection that serves as an output terminal Tout for driving the ultrasound transducer UST. As mentioned above, other implementations are also contemplated in which a combination of both (MOS)FET and bipolar transistors are used.

In-use the half-bridge output stage may be operated such that output terminal Tout, and thus a first electrode of optional ultrasound transducer UST, is alternately coupled to each of first power rail VDDH and second power rail VSS by applying a voltage to a control input, specifically a gate, of each of high-side transistor MP0 and low-side transistor MN0, i.e. g_MP0 and g_MN0. In the first implementation wherein high-side transistor MP0 is a p-channel enhancement (MOS)FET and low-side transistor MN0 is an n-channel enhancement (MOS)FET, either transistor may be switched on, i.e. into the conducting state, by providing the respective transistor with a gate-source voltage that exceeds its gate-source threshold voltage. Control inputs g_MN0 and g_MP0 may thus be used to alternately switch low-side transistor MN0 and high-side transistor MP0 into each of the conducting state and the non-conducting state such that low-side transistor MN0 and high-side transistor MP0 are in opposite states. In so doing, output terminal Tout and thus the first electrode of optional ultrasound transducer UST may be alternately coupled to each of first power rail VDDH and second power rail VSS. A second electrode of optional ultrasound transducer UST is coupled to power rail VBIAS. In one exemplary configuration power rail VBIAS may arranged to supply a third voltage of approximately -50 Volts. Other bias voltages, positive and negative, and also 0 Volts, may alternatively be used. In so doing, by alternately coupling output terminal Tout to each of first power rail VDDH and second power rail VSS, a potential difference across ultrasound transducer UST is modulated between two voltage levels: VDDH-VBIAS, and VSS-VBIAS.

In a preferred configuration, high-side output transistor MP0 and low-side output transistor MN0 each comprise a so-called high-voltage transistor. One exemplary chip technology that may be used to fabricate high-voltage transistors is ONC18 with the I4T 45V option. High-voltage transistors may be used in order to withstand the voltages that are applied across the electrodes of ultrasound transducer UST, for example in the contemplated application of IVUS imaging. In this respect, it may be necessary to switch a voltage of a few tens of volts, typically between 50 Volts and 80 - 90 Volts, across ultrasound transducer UST.

In order to switch such voltages, a level-shifter is used to switch the control input of high-side transistor MP0. With reference to Fig. 1, if purely for example, VDDH = 40 Volts, VSS = 0 Volts and the absolute value of the threshold voltage of each of high-side enhancement transistor MP0 and low-side enhancement transistor MN0, is 0.7 Volts, high-side transistor MP0 requires a voltage at its control input g_MP0 to be modulated between approximately that of the first power rail, i.e. VDDH at approximately 40 Volts, and 37 Volts in order to switch it between the non-conducting state and the conducting state.

With reference to Fig. 1, level-shifter LSH is provided for switching high-side transistor MP0 between a conducting state and a non-conducting state by controlling a gate-source voltage of output p-channel FET MP0. Level-shifter LSH may, as illustrated above, be used to provide the necessary modulation voltages at gate g_MP0 of high-side transistor MP0, for example by providing a first gate-source voltage having a magnitude that exceeds the threshold voltage for switching output p-channel FET MP0 into the conducting state, and a second gate-source voltage having a magnitude that is less than the threshold voltage for switching output p-channel FET MP0 into the non-conducting state. Upon activation, level-shifter LSH in Fig. 1 may provide these voltage levels at its output, i.e. at gate g_MP0 of high-side transistor MP0. Following the exemplary values in the preceding paragraph, the first gate-source voltage may exemplarily be 3 Volts, which with VDDH = 40 Volts requires a gate voltage of 37 Volts; and the second gate-source voltage may exemplarily be zero volts, which with VDDH = 40 Volts requires a gate voltage of 40 Volts. Other voltages than these examples may clearly alternatively be used.

By contrast the control of low-side transistor MN0 in the configuration of Fig. 1 is less complex than that of the high-side transistor because its source is referenced to second power rail VSS. Lower absolute-value voltages may therefore be used to control low-side transistor MN0. An absolute value of the gate-source threshold voltage of low-side enhancement transistor MN0 may for example be 0.7 Volts. A voltage at its control input g_MN0 may exemplarily be modulated between a voltage that is less than its gate-source threshold voltage, for example the voltage of the second power rail VSS, i.e. approximately 0V, and a voltage that exceeds its gate-source threshold voltage, for example 3 Volts, in order to switch low-side transistor MN0 between the non-conducting state and the conducting state. Switching this, relatively lower voltage, can typically be achieved in the absence of a level-shifter and is therefore less complex than controlling high-side transistor MP0 since no level shifter is required.

Drawbacks of using so-called high-voltage transistors, for example as high-side transistor MP0 and low-side transistor MN0, typically include their large size and large stray capacitances, the latter typically giving rise to reduced switching speeds as compared to transistors that operate at lower voltages. The thin gate oxide used in these devices may also limit the maximum gate-source voltages that may be applied to these devices without damaging the transistor.

According to the present disclosure, discharge switch DSW controls a switching rate of high-side transistor MP0 by discharging the input capacitance of high-side transistor MP0 when high-side transistor MP0 is switched into the non-conducting state. Discharge switch DSW may be controlled via a signal received at its control input SWc, which may for example be received from a controller CTRL as shown in Fig. 2. Thus when high-side transistor MP0 is an output p-channel FET and low-side transistor MN0 is output n-channel FET, level-shifter LSH switches high-side transistor MP0 between a conducting state and a non-conducting state by respectively controlling a gate-source voltage of output p-channel FET MP0, and discharge switch DSW controls a switching rate of high-side transistor MP0 by discharging an input capacitance of high-side transistor MP0 when high-side transistor MP0 is switched into the non-conducting state by discharging a gate-source capacitance of the output p-channel FET MP0.

In a corresponding manner, when high-side transistor MP0 is an output pnp bipolar transistor and low-side transistor is an output npn bipolar transistor, level-shifter LSH switches high-side transistor MP0 between a conducting state and a non-conducting state by controlling a base-emitter voltage of the output pnp bipolar transistor, and discharge switch DSW controls a switching rate of the high-side transistor MP0 by discharging an input capacitance of high-side transistor MP0 when the high-side transistor MP0 is switched into the non-conducting state by discharging a base-emitter capacitance of the output pnp bipolar transistor.

Thus, discharge switch DSW may be used to accelerate switching-off the power to high-side transistor MP0. As mentioned above, this can have particular advantages when so-called high-voltage transistors are used in the half-bridge output stage since it can mitigate their poor switching rate.

Fig. 2 illustrates an ultrasound transducer driver circuit UTDC that includes a control circuit CTRL. Ultrasound transducer driver circuit UTDC in Fig. 2 corresponds to Fig. 1, and additionally includes control circuit CTRL. Control circuit CTRL may include hardware or software or a processor or a combination thereof that perform one or more of the following functions. Control circuit CTRL controls level-shifter LSH and control input g_MN0 of low-side transistor MN0 such that low-side transistor MN0 and high-side transistor MP0 are alternately switched into each of the conducting state and the non-conducting state. Control circuit CTRL also causes discharge switch DSW to discharge the input capacitance of high-side transistor MP0 when high-side transistor MP0 is switched into the non-conducting state. Control circuit CTRL thus provides control signals with the necessary timing in order to control level-shifter LSH and half-bridge output stage MP0, MN0. Control circuit CTRL may in some examples be provided by so-called low-voltage transistors. Advantageously this may result in a more compact ultrasound transducer driver circuit UTDC with increased switching rates.

In a preferred implementation, control circuit CTRL in Fig. 2 includes a break-before-make switching operation wherein high-side transistor MP0 is switched into the non-conducting state before low-side transistor MN0 is switched into the conducting state, and wherein low-side transistor MN0 is switched into the non-conducting state before high-side transistor MP0 is switched into the conducting state. In so doing it is prevented that significant current flows between first power rail VDDH and second power rail VSS, via both high-side transistor MP0 and low-side transistor MN0.

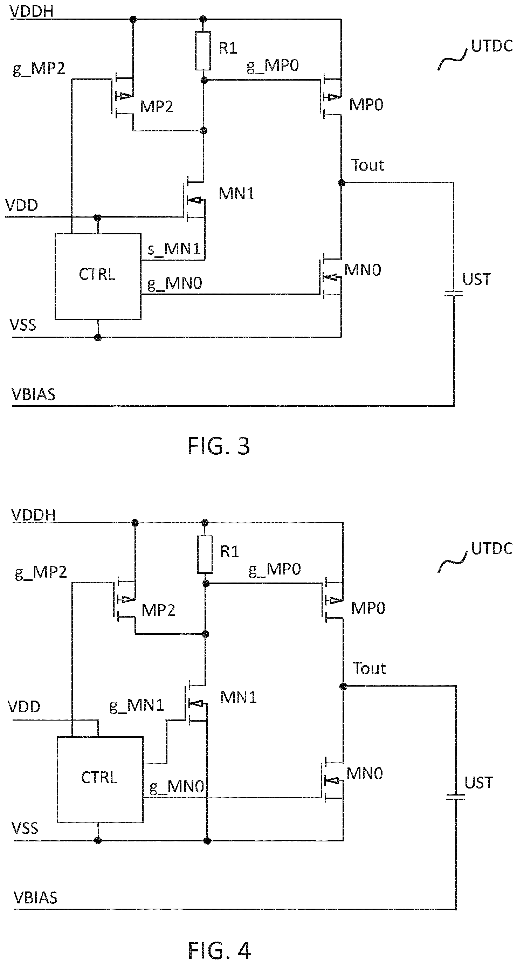

In general, level-shifter LSH in Fig. 1 and Fig. 2 may be provided by numerous techniques. Fig. 3 of the document by Eric J. Wildi, John P. Walden, Michael S. Adler entitled "A 500V/25A half-bridge IC with on-chip control logic", Digest of Technical Papers of the 28th IEEE International Solid-State Circuits Conference ISSCC1985, New York, USA, Feb. 1985, pp. 266 - 267 illustrates one such implementation. In an alternative, preferred implementation, a combination of a transistor MN1 and a pullup component R1 is used, as illustrated in Fig. 3 herein, which illustrates an ultrasound transducer driver circuit UTDC that includes an exemplary level-shifter provided by first current source MN1 and first pullup component R1.

Fig. 3 corresponds to Fig. 2, and additionally includes a level-shifter that is provided by first current source MN1 and first pullup component R1, and a discharge switch in the form of discharge p-channel FET MP2. First pullup component R1 is illustrated as being a resistor, although this resistor may alternatively be implemented by means of e.g. a FET or a bipolar transistor operated as a resistor. In-operation the level-shifter modulates a voltage applied to control input g_MP0 of high-side transistor MP0 by alternately switching a current generated by first current source MN1 between a first magnitude and a second magnitude such that high-side transistor MP0 is switched respectively between the conducting state and the non-conducting state. Preferably the second magnitude is smaller than the first magnitude. The second magnitude may be a negligible, or zero current. In the arrangement of Fig. 3, control circuit CTRL operates by modulating a voltage supplied to the source of first current source MN1, which in turn modulates a gate-source voltage of first current source MN1, such that first current source MN1 is switched between the conducting state, when a current with the first magnitude is generated, and the non-conducting state when a current with the second magnitude is generated, the latter being typically negligible. When the current with the first magnitude is generated, a potential difference is generated across first pullup component R1 thereby providing high-side transistor MP0 with a gate-source voltage that exceeds its threshold voltage and thus high-side transistor MP0 is switched into the conducting state. When the current with the second magnitude is generated, preferably negligible current is generated, and first pullup component R1 couples control input g_MP0 of high-side transistor MP0 to the first power rail VDDH, thereby providing high-side transistor MP0 with a negligible gate-source voltage. Consequently high-side transistor MP0 is switched into the non-conducting state.

In more detail, with reference to Fig. 3, high-side transistor MP0 in ultrasound transducer driver circuit UTDC includes output p-channel FET MP0. First current source MN1 may include a first n-channel FET having a drain coupled to a gate of the output p-channel FET MP0, and a source coupled to a reference voltage s_MN1, and the first pullup component R1 may be coupled between the gate g_MP0 of the output p-channel FET MP0 and a source of the output p-channel FET MP0. In a preferred configuration, first n-channel FET is a high-voltage transistor.

An alternative level-shifter to that in Fig. 3 is illustrated in Fig. 4, which illustrates another ultrasound transducer driver circuit UTDC that includes an exemplary level-shifter provided by first current source MN1 and first pullup component R1. Fig. 4 corresponds to Fig. 3, except that current source MN1 of the level-shifter is controlled by modulating a voltage at its gate input g_MN1 whilst its source is held at the voltage of second power rail VSS. The gate-source voltage of current source MN1 is controlled in a similar manner as described in relation to Fig. 3 in order to switch high-side transistor MP0 between the conducting state and the non-conducting state. Again, in a preferred configuration, first n-channel FET is a high-voltage transistor.

The level-shifter illustrated in Fig. 3 and Fig. 4 thus provides control over high-side FET MP0.

As mentioned above, both Fig. 3 and Fig. 4 include a discharge switch in the form of discharge p-channel FET MP2. In a preferred configuration, p-channel FET MP2 is a low-voltage transistor. In these Figures, discharge switch MP2 is coupled between a gate g_MP0 of output p-channel FET MP0 and a source of output p-channel FET MP0. In-use, control circuit CTRL modulates a gate-source voltage of discharge switch MP2 such that discharge switch MP2 is switched between a non-conducting state and a conducting state in order to discharge a gate-source capacitance of output p-channel FET MP0. In an alternative configuration, not illustrated, a discharge pnp bipolar transistor may instead be used as discharge switch MP2. Alternatively high-side transistor MP0 may include an output pnp bipolar transistor and low-side transistor MN0 may include an output npn bipolar transistor. The discharge pnp bipolar transistor may thus be coupled between a gate g_MP0 of output p-channel FET MP0 and a source of output p-channel FET MP0, or between a base of the output pnp bipolar transistor and an emitter of the output pnp bipolar transistor. In a similar manner as described in relation to Fig. 3 and Fig. 4, control circuit CTRL may modulate a voltage between the base of the discharge pnp bipolar transistor MP2 and the emitter of the discharge pnp bipolar transistor MP2 in order to discharge the gate-source capacitance of the output p-channel FET MP0, or to likewise discharge the base-emitter capacitance of the output pnp bipolar transistor, when the high-side transistor MP0 is switched into the non-conducting state.

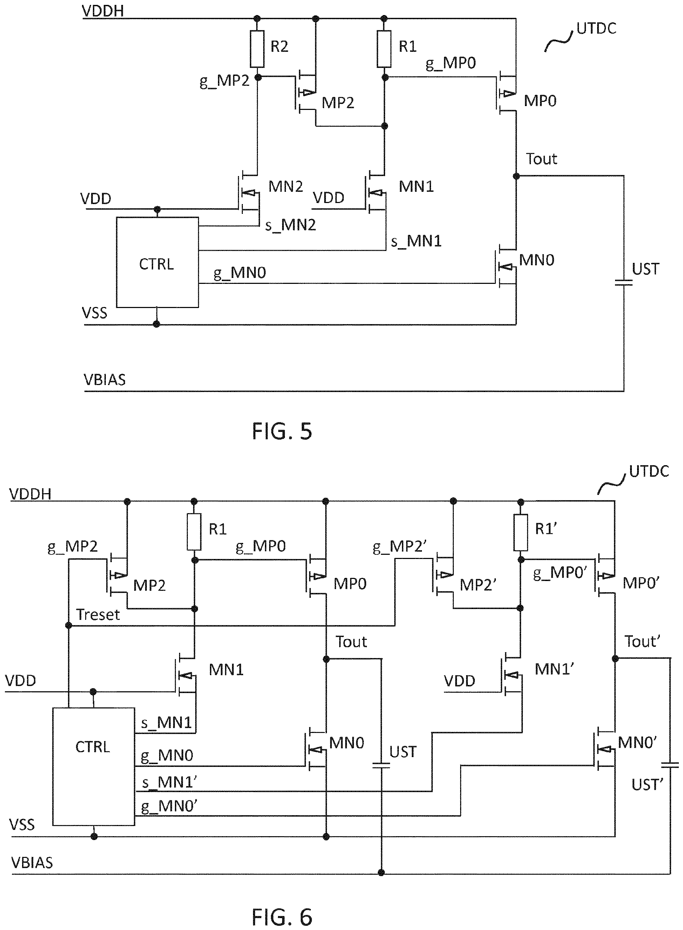

An additional level-shifter may also be used in order to drive control input g_MP2 of discharge switch MP2 illustrated in Fig. 3 and Fig. 4. This is shown in Fig. 5, which illustrates an ultrasound transducer driver circuit UTDC that includes a second level-shifter exemplarily provided by second current source MN2 and second pullup component R2. Fig. 5 corresponds to Fig. 3, and additionally includes second current source MN2 and second pullup component R2. In a preferred configuration, second current source MN2 includes a high-voltage transistor. Second pullup component R2 is illustrated in Fig. 5 as a resistor, although this may alternatively be implemented by means of a FET or a bipolar transistor operated as a resistor. In-operation the second level-shifter modulates a voltage applied to control input g_MP2 of discharge switch MP2 by alternately switching a current generated by second current source MN2 between a first value and a second value such that discharge switch MP2 is respectively switched between the conducting state and the non-conducting state. The state of discharge switch MP2, i.e. conducting or non-conducting, is determined by the current generated by second current source MN2 and the resistance of second pullup component R2. In order for discharge switch MP2 to be in the conducting state it is required that the first magnitude, Iₒₙ, satisfies: Iₒₙ×R2 > V_{threshold}, wherein V_{threshold} is the absolute value of the gate-source threshold voltage of discharge switch MP2. In order for discharge switch MP2 to be in the non-conducting state it is required that the second magnitude, I_{off}, satisfies: I_{off}×R2 < V_{threshold}. Preferably the second value has a magnitude that is smaller than the magnitude of the first value. The second value may be zero, or a negligible current. In the arrangement of Fig. 5, control circuit CTRL operates by modulating a gate-source voltage of second current source MN2, such that second current source MN2 is switched between the conducting state, when a current with the first value is generated, and the non-conducting state when a current with the second value is generated, the latter being typically negligible. When the current with the first value is generated, a potential difference across second pullup component R2 provides discharge switch MP2 with a gate-source voltage that exceeds its threshold voltage and thus discharge switch MP2 is switched into the conducting state. When the current with the second value, preferably negligible current, is generated, second pullup component R2 couples control input g_MP2 of discharge switch MP2 to the first power rail VDDH, providing discharge switch MP2 with a negligible gate-source voltage. Consequently discharge switch MP2 is switched into the non-conducting state.

The use of the second level-shifter in relation to Fig. 5 thus provides control over discharge switch MP2 whilst obviating the need for high-voltage transistors in control circuit CTRL.

Thus, with continued reference to Fig. 5, an ultrasound transducer driver circuit is disclosed wherein discharge switch MP2 includes a discharge p-channel FET or a discharge pnp bipolar transistor, and wherein the discharge switch MP2 is coupled between i) a gate g_MP0 of the output p-channel FET MP0 and a source of the output p-channel FET MP0, or between ii) a base of the output pnp bipolar transistor and an emitter of the output pnp bipolar transistor. The circuit also includes a second level-shifter MN2, R2. Control circuit CTRL causes second level-shifter MN2, R2 to switch the discharge switch DSW, MP2 between a non-conducting state and a conducting state for i) discharging the gate-source capacitance of the output p-channel FET MP0, or for ii) discharging the base-emitter capacitance of the output pnp bipolar transistor, when the high-side transistor MP0 is switched into the non-conducting state.

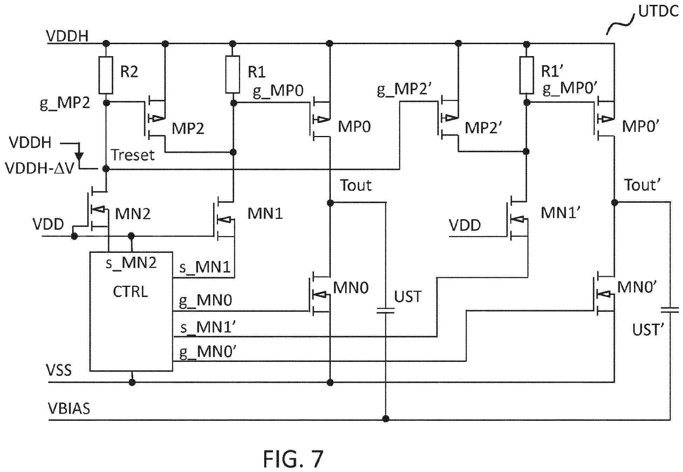

Figures 1 - 5 have been described above in relation to control circuit CTRL controlling only a single half-bridge output stage. However it is to be appreciated that multiple half-bridge output stages may be controlled by a single control circuit CTRL in a similar manner. This is illustrated in Fig. 6 and Fig. 7 which each include two half-bridge output stages. Advantageously a single control output from the control circuit CTRL can thus be used to synchronously toggle discharge transistors MP2, MP2' between the conductive state and the non-conductive state, leading to discharge of the charged input capacitances of the p-channel FETs MP0, MP0' in multiple such half-bridge output stages. Avoiding the duplication of such control circuitry is particularly beneficial in IVUS applications wherein the tight space constraints, the large number of half-bridge output stages, for example 8, 16, or 24 or more, and the desire to minimize the number of control signals, and especially the number of high-voltage transistors used in the transducer driver circuit confound circuit design.

Thereto, Fig. 6 illustrates an ultrasound transducer driver circuit UTDC that includes a second half-bridge output stage MP0', MN0' for driving a second ultrasound transducer UST'. Fig. 7 illustrates an ultrasound transducer driver circuit UTDC that includes a second half-bridge output stage MP0', MN0' for driving a second ultrasound transducer UST' and a second level-shifter provided by second current source MN2 and second pullup component R2. Fig. 6 operates in the same manner as described in relation to Fig. 3, with the exception that two half-bridge output stages are controlled by control circuit CTRL. Fig. 7 operates in the same manner as described in relation to Fig. 5, with the exception that two half-bridge output stages are controlled by control circuit CTRL. As compared to Fig. 6, in Fig. 7 the two half-bridge output stages are additionally controlled by control circuit CTRL via second level-shifter MN2, R2.

Thus, with reference to Fig. 6 and Fig. 7 an ultrasound transducer driver circuit UTDC includes a second half-bridge output stage for driving a second ultrasound transducer UST', the second half-bridge output stage comprising a second high-side transistor MP0' and a second low-side transistor MN0'; a third level-shifter MN1', R1'; and a second discharge switch MP2'. In a first implementation i) the second high-side transistor MP0' of the second half-bridge output stage comprises a second output p-channel FET and the second low-side transistor MN0' of the second half-bridge output stage comprises a second output n-channel FET MN0. In a second implementation ii) the second high-side transistor of the second half-bridge output stage comprises a second output pnp bipolar transistor and the second low-side transistor MN0' of the second half-bridge output stage comprises a second output npn bipolar transistor. The third level-shifter MN1', R1' is configured to switch the second high-side transistor MP0' between a conducting state and a non-conducting state by controlling, in the first implementation i) a gate-source voltage of the second output p-channel FET MP0', or in the second implementation ii) a base-emitter voltage of the second output pnp bipolar transistor. The second discharge switch MP2' is configured to control a switching rate of the second high-side transistor MP0' by discharging an input capacitance of the second high-side transistor MP0' when the second high-side transistor MP0' is switched into the non-conducting state by, in the first implementation i) discharging a gate-source capacitance of the second output p-channel FET MP0', or in the second implementation ii) discharging a base-emitter capacitance of the second output pnp bipolar transistor. Control circuit CTRL is further configured to control the third level-shifter MN1', R1' and a control input g_MN0' of the second low-side transistor MN0' such that the second low-side transistor MN0' and the second high-side transistor MP0' are alternately switched into each of the conducting state and the non-conducting state. Control circuit CTRL is further configured to cause the second discharge switch MP2' to discharge the input capacitance of the second high-side transistor MP0' simultaneously with the discharging of the input capacitance of the high-side transistor MP0 by the discharge switch MP2.

As compared to Fig. 6 the ultrasound transducer driver circuit of Fig. 7 also includes a second level-shifter MN2, R2. Control circuit CTRL causes second level-shifter MN2, R2 to provide a reset signal Treset that causes discharge switch MP2 to discharge the input capacitance of the high-side transistor MP0, and at the same time, the second discharge switch MP2' to discharge the input capacitance of the second high-side transistor MP0'. As illustrated in Fig. 7, the reset signal Treset may be switched between the voltages VDDH and VDDH-ΔV wherein ΔV exceeds the magnitude of the gate-source threshold voltage of transistor MP2 in order to achieve this. Transistor MN2 in second level-shifter MN2, R2 may include a high-voltage FET or bipolar transistor, which permits control circuit CTRL to be implemented with low-voltage transistors.

Any of the circuits described herein may be coupled to an ultrasound transducer UST as illustrated in the Figures. The use of the circuits with CMUT, or PMUT and other ultrasound transducers is contemplated.

Moreover, any of the ultrasound transducer driver circuits described herein may be incorporated into an application specific integrated circuit, i.e. ASIC.

Any of the ultrasound transducer driver circuits described herein, or the ASIC, may be incorporated into an ultrasound sensing system or an ultrasound imaging system, which may be 2D or 3D, and which may without limitation, be an IVUS imaging system, a "TEE" transesophageal, a "TTE" transthoracic, a "TNE" transnasal, an "ICE" intracardiac, or a "TRUS" transrectal ultrasound imaging system. Use of the ultrasound transducer driver circuits or the ASIC is contemplated in both invasive, i.e. internal and external imaging probes, as well as in 2D and 3D ultrasound imaging systems.

In summary, an ultrasound transducer driver circuit UTDC has been provided which includes a half-bridge output stage for driving an ultrasound transducer UST. The half-bridge output stage comprises a high-side transistor MP0 and a low-side transistor MN0, a level-shifter LSH, MN1, R1, and a discharge switch DSW, MP2. In a first implementation i) the high-side transistor MP0 comprises an output p-channel FET and the low-side transistor comprises an output n-channel FET MN0. In a second implementation ii) the high-side transistor comprises an output pnp bipolar transistor and the low-side transistor comprises an output npn bipolar transistor. The level-shifter LSH, MN1, R1 switches the high-side transistor MP0 between a conducting state and a non-conducting state by controlling, in the first implementation i) a gate-source voltage of the output p-channel FET MP0, or in the second implementation ii) a base-emitter voltage of the output pnp bipolar transistor. The discharge switch DSW, MP2 controls a switching rate of the high-side transistor MP0 by discharging an input capacitance of the high-side transistor MP0 when the high-side transistor MP0 is switched into the non-conducting state by, in the first implementation i) discharging a gate-source capacitance of the output p-channel FET MP0, or in the second implementation ii) discharging a base-emitter capacitance of the output pnp bipolar transistor.

Various options have been described in relation to the ultrasound transducer driver circuits disclosed herein, and it is noted that the various embodiments may be combined to achieve further advantageous effects. Any reference signs in the claims should not be construed as limiting the scope of the invention.

## Claims

1. Ultrasound transducer driver circuit (UTDC) comprising:
a half-bridge output stage for driving an ultrasound transducer (UST), the half-bridge output stage comprising a high-side transistor (MP0) and a low-side transistor (MN0);
a level-shifter (LSH, MN1, R1); and
a discharge switch (DSW, MP2);
wherein i) the high-side transistor (MP0) comprises an output p-channel FET and the low-side transistor comprises an output n-channel FET (MN0), or ii) the high-side transistor comprises an output pnp bipolar transistor and the low-side transistor comprises an output npn bipolar transistor;
wherein the level-shifter (LSH, MN1, R1) is configured to switch the high-side transistor (MP0) between a conducting state and a non-conducting state by respectively controlling i) a gate-source voltage of the output p-channel FET (MP0), or ii) a base-emitter voltage of the output pnp bipolar transistor; and
wherein the discharge switch (DSW, MP2) is configured to control a switching rate of the high-side transistor (MP0) by discharging an input capacitance of the high-side transistor (MP0) when the high-side transistor (MP0) is switched into the non-conducting state by respectively i) discharging a gate-source capacitance of the output p-channel FET (MP0), or ii) discharging a base-emitter capacitance of the output pnp bipolar transistor.

2. The ultrasound transducer driver circuit according to claim 1 further comprising a control circuit (CTRL);
wherein the control circuit (CTRL) is configured to control the level-shifter (LSH, MN1, R1) and a control input (g_MN0) of the low-side transistor (MN0) such that the low-side transistor (MN0) and the high-side transistor (MP0) are alternately switched into each of the conducting state and the non-conducting state; and
wherein the control circuit (CTRL) is further configured to cause the discharge switch (DSW, MP2) to discharge the input capacitance of the high-side transistor (MP0) when the high-side transistor (MP0) is switched into the non-conducting state.

3. The ultrasound transducer driver circuit according to claim 2 wherein the control circuit (CTRL) further comprises a break-before-make switching operation wherein the high-side transistor (MP0) is switched into the non-conducting state before the low-side transistor (MN0) is switched into the conducting state, and wherein the low-side transistor (MN0) is switched into the non-conducting state before the high-side transistor (MP0) is switched into the conducting state.

4. The ultrasound transducer driver circuit according to claim 2 wherein the discharge switch (DSW, MP2) comprises a discharge p-channel FET (MP2) or a discharge pnp bipolar transistor, and wherein the discharge switch (DSW, MP2) is coupled respectively between i) a gate (g_MP0) of the output p-channel FET (MP0) and a source of the output p-channel FET (MP0), or between ii) a base of the output pnp bipolar transistor and an emitter of the output pnp bipolar transistor; and further comprising a second level-shifter (MN2, R2); and
wherein the control circuit (CTRL) is further configured to cause the second level-shifter (MN2, R2) to switch the discharge switch (DSW, MP2) between a non-conducting state and a conducting state for i) discharging the gate-source capacitance of the output p-channel FET (MP0), or for ii) discharging the base-emitter capacitance of the output pnp bipolar transistor, when the high-side transistor (MP0) is switched into the non-conducting state.

5. The ultrasound transducer driver circuit according to any one of claims 1 - 4 wherein the high-side transistor (MP0) and the low-side transistor (MN0) are coupled in series between a first power rail (VDDH) and a second power rail (VSS) such that i) a source of the output p-channel FET (MP0) is coupled to the first power rail (VDDH) and such that a source of the output n-channel FET (MN0) is coupled to the second power rail (VSS), and wherein a drain of the output p-channel FET (MP0) is coupled to a drain of the output n-channel FET (MN0) to provide an output terminal (Tout) for driving the ultrasound transducer (UST), or such that ii) an emitter of the output pnp bipolar transistor is coupled to the first power rail (VDDH) and such that an emitter of the output npn bipolar transistor is coupled to the second power rail (VSS), and wherein a collector of the output pnp bipolar transistor is coupled to a collector of the output npn bipolar transistor to provide an output terminal (Tout) for driving the ultrasound transducer (UST).

6. The ultrasound transducer driver circuit according to any one of claims 1 - 5 wherein the level-shifter (LSH, MN1, R1) comprises a first current source (MN1) and a first pullup component (R1) configured to modulate a voltage applied to a control input (g_MP0) of the high-side transistor (MP0) by alternately switching a current generated by the first current source (MN1) between a first magnitude and a second magnitude such that the high-side transistor (MP0) is respectively switched between the conducting state and the non-conducting state.

7. The ultrasound transducer driver circuit according to claim 5 wherein the level-shifter (LSH, MN1, R1) comprises a first current source (MN1) and a first pullup component (R1) configured to modulate a voltage applied to a control input (g_MP0) of the high-side transistor (MP0) by alternately switching a current generated by the first current source (MN1) between a first magnitude and a second magnitude such that the high-side transistor (MP0) is respectively switched between the conducting state and the non-conducting state;
wherein the first pullup component (R1) is coupled between the first power rail (VDDH) and a control input (g_MP0) of the high-side transistor (MP0), and wherein the first current source (MN1) is coupled to the control input (g_MP0) of the high-side transistor (MP0); and
wherein when the first current source (MN1) generates the current with the first magnitude, a voltage exceeding a threshold voltage of the high-side transistor (MP0) is applied to the control input (g_MP0) of the high-side transistor (MP0) such that the high-side transistor (MP0) is switched into the conducting state, and
wherein when the current source (MN1) generates the current with the second magnitude, a voltage less than the threshold voltage of the high-side transistor (MP0) is applied to the control input (g_MP0) of the high-side transistor (MP0) such that the high-side transistor (MP0) is switched into the non-conducting state, the second magnitude being smaller than the first magnitude.

8. The ultrasound transducer driver circuit according to claim 4 wherein the second level-shifter (MN2, R2) comprises a second current source (MN2) and a second pullup component (R2) configured to modulate a voltage applied to a control input (g_MP2) of the discharge switch (DSW, MP2) by alternately switching a current generated by the second current source (MN2) between a first value and a second value such that the discharge switch (DSW, MP2) is switched between the conducting state and the non-conducting state.

9. The ultrasound transducer driver circuit according to claim 8 wherein the second current source (MN2) comprises a second n-channel FET having a drain coupled to the control input (g_MP2) of the discharge switch (DSW, MP2), and a source coupled to a second reference voltage (S_MN2), and wherein the second pullup component (R2) is coupled between the control input (g_MP2) of the discharge switch (DSW, MP2) and a source of the output p-channel FET (MP0), or wherein the second current source comprises a second npn bipolar transistor having a collector coupled to the control input (g_MP2) of the discharge switch (DSW, MP2), and an emitter coupled to a second reference voltage (s_MN2), and wherein the second pullup component (R2) is coupled between the control input (g_MP2) of the discharge switch (DSW, MP2) and a source of the output p-channel FET (MP0).

10. The ultrasound transducer driver circuit according to claim 2 further comprising:
a second half-bridge output stage for driving a second ultrasound transducer (UST'), the second half-bridge output stage comprising a second high-side transistor (MP0') and a second low-side transistor (MN0');
a third level-shifter (MN1', R1'); and
a second discharge switch (MP2');
wherein i) the second high-side transistor (MP0') comprises a second output p-channel FET and the second low-side transistor (MN0') comprises a second output n-channel FET, or ii) the second high-side transistor (MP0') comprises a second output pnp bipolar transistor and the second low-side transistor (MN0') comprises a second output npn bipolar transistor;
wherein the third level-shifter (MN1', R1') is configured to switch the second high-side transistor (MP0') between a conducting state and a non-conducting state by respectively controlling i) a gate-source voltage of the second output p-channel FET (MP0'), or ii) a base-emitter voltage of the second output pnp bipolar transistor; and
wherein the second discharge switch (MP2') is configured to control a switching rate of the second high-side transistor (MP0') by discharging an input capacitance of the second high-side transistor (MP0') when the second high-side transistor (MP0') is switched into the non-conducting state by respectively i) discharging a gate-source capacitance of the second output p-channel FET (MP0'), or ii) discharging a base-emitter capacitance of the second output pnp bipolar transistor;
wherein the control circuit (CTRL) is further configured to control the third level-shifter (MN1', R1') and a control input (g_MN0') of the second low-side transistor (MN0') such that the second low-side transistor (MN0') and the second high-side transistor (MP0') are alternately switched into each of the conducting state and the non-conducting state; and
wherein the control circuit (CTRL) is further configured to cause the second discharge switch (MP2') to discharge the input capacitance of the second high-side transistor (MP0') simultaneously with the discharging of the input capacitance of the high-side transistor (MP0) by the discharge switch (MP2).

11. The ultrasound transducer driver circuit according to claim 10 further comprising a second level-shifter (MN2, R2); and
wherein the control circuit (CTRL) is further configured to cause the second level-shifter (MN2, R2) to provide a reset signal (Treset) to cause the discharge switch (MP2) to discharge the input capacitance of the high-side transistor (MP0) and the second discharge switch (MP2') to discharge the input capacitance of the second high-side transistor (MP0').

12. The ultrasound transducer driver circuit (UTDC) according to any one of claims 1 - 11 further comprising an ultrasound transducer (UST), and wherein the ultrasound transducer (UST) is coupled to the output terminal (Tout).

13. Application specific integrated circuit comprising the ultrasound transducer driver circuit according to any one of claims 1 - 11.

14. Ultrasound imaging system comprising the ultrasound transducer driver circuit according to any one of claims 1 - 12, or the application specific integrated circuit according to claim 13.
